Europäisches Patentamt

European Patent Office

Office européen des brevets

(11) Publication number: **0 442 196 A2**

# EUROPEAN PATENT APPLICATION

(21) Application number: **90311594.7**

(22) Date of filing: **23.10.90**

(51) Int. Cl.⁵: **G03F 1/16**

(30) Priority: **13.02.90 US 479113**

(43) Date of publication of application:
**21.08.91 Bulletin 91/34**

(84) Designated Contracting States:
**BE CH DE ES FR GB IT LI LU NL SE**

(71) Applicant: **MACDERMID INCORPORATED**
**245 Freight Street**
**Waterbury, Connecticut 06702(US)**

(72) Inventor: **Kukanskis, Peter E.**
**245 Quassapaug Road**
**Woodbury, Connecticut 0679(US)**

(74) Representative: **Pendlebury, Anthony et al**
**PAGE, WHITE & FARRER 54 Doughty Street**
**London WC1N 2LS(GB)**

(54) Method for applying liquid photoresist to planar substrate surfaces.

(57) The surfaces of a planar substrate (20) used in the fabrication of printed circuit boards are provided with a substantially uniform and defect-free coating of liquid photoresist by roller coating in a process in which a first coating roller (12,16) is used to provide a first layer of liquid photoresist on the substrate surface in less than the ultimately desired thickness, and the thus-treated substrate, without any change in planar orientation, is then provided with additional photoresist, to the ultimately desired thickness, using a distinct (i.e., separate) second coating roller (14,18).

## METHOD FOR APPLYING LIQUID PHOTORESIST TO PLANAR SUBSTRATE SURFACES

The present invention relates generally to the fabrication of printed circuit boards, more particularly to the provision of a coating of liquid photoresist on planar substrate surfaces utilized in the manufacture of printed circuit boards, and still more particularly to the provision of a coating of liquid positive-acting photoresist on one or both surfaces of a metal-clad inner-layer utilized in the manufacture of multilayer printed circuit boards.

In the manufacture of printed circuit boards, photoresists are widely employed for defining a desired pattern of circuitry. Photoresists are light-sensitive organic compositions which are applied as a substantially uniform layer over a substrate surface and then selectively exposed to radiation of appropriate wavelength through a mask of defined pattern. Depending on the type of photoresist employed, i.e., positive-acting or negative-acting, exposure brings about changes in the composition such that, upon development, exposed or non-exposed areas, as the case may be, are selectively removed from the substrate, leaving behind a resist pattern which, depending upon the printed circuit board fabrication process, is either a positive or negative of the desired circuitry pattern. The resist pattern thus defines areas which will be resistant to etching processes or resistant to plating processes, etc. employed in the ultimate fabrication of the printed circuit board.

In order to obtain accurate patterns using imagewise-exposed photoresist, it is necessary that the photoresist be applied to the substrate in question as a uniform layer or coating of substantially uniform thickness. A number of means can be employed for arriving at suitable coatings using liquid photoresists, including roller coating, dip coating, spray coating, electrophoretic coating, curtain coating, screen coating and the like.

Generally speaking, roller coating offers a relatively simply and economic means for application of photoresist coatings to a substrate, and this method has been widely employed in the industry. Roller coating methods and apparatus are known for effecting both one-sided and double-sided coating of photoresist on planar substrates used in the manufacture of circuit boards. As a practical matter, however, experience has shown that even with the cleanest substrate surfaces, roller applied photoresist coatings very often exhibit coating defects where no photoresist is present. These defects ("pin holes") can range in size from microscopic (e.g., 25 to 50 um in diameter) to substantially larger (e.g., 1 mm in diameter), and in either case, the subsequent imagewise exposure and development of photoresist coatings containing such defects can lead to shorts or opens in the intended continuous circuit paths. Defective panels or boards of this type must either be scrapped entirely or subjected to time-consuming repair techniques.

Suggestions have been made for double-processing substrates in order to minimize coating defects, i.e., subjecting the substrate to roller coating, rotating it 90°, and then returning it to the roller coater for additional application of photoresist. See DeForest, W.S., "Photoresist", pp. 96 and 142 (McGraw-Hill 1975). The handling involved in such a process is very disadvantageous and often counterproductive, and the increased costs and decreased throughput associated therewith are such as to make such an approach highly unattractive.

According to the present invention there is provided a method for applying a substantially uniform, substantially defect-free coating of liquid photoresist of predetermined desired thickness to a selected planar surface of a planar substrate having upper and lower planar surfaces, the method involving serial advancement of the planar surface into contact with a first coating roller which applies liquid photoresist to the substrate surface as a layer whose thickness is less than the predetermined desired thickness of photoresist coating, followed by advancement of the planar surface, without change in its planar orientation, into contact with a second coating roller which applies additional liquid photoresist to the substrate surface in an amount such that, together with the liquid photoresist applied by the first coating roller, the substrate surface is provided with a substantially uniform, substantially defect-free coating of liquid photoresist of the predetermined desired thickness. The photoresist-coated substrate surface is then processed in known manner for drying, imagewise exposure, development, etc.

The first and second coating rollers per se can be selected from any of the conventional coating rollers of known design and materials of construction. In particular, the first and/or second coating roller can be a smooth rubber roller or a threaded (or grooved) roller, and in the preferred embodiment of the invention, the first coating roller will be a smooth rubber roller while the second coating roller will be a threaded roller. Examples of such coating rollers and design considerations with respect thereto can be found in DeForest, supra, at pages 137-143, incorporated herein by reference.

The first and second coating rollers are components of one or more roller coating devices ("roller coaters") which are associated with stationary or rotating doctor bars or rollers or a stationary doctor blade, support or drive rollers, liquid pumps, conveyoring arrangements, drive means, backing plates for single-sided coating, etc. See DeForest, supra. Each of the first and second coating roller can be components of a single roller coater or, alternatively, each of the first and second coating rollers can be embodied in separate roller coaters.

The foregoing process is equally applicable to single-side and double-side coating. For double-side coating, the opposed substrate surfaces are typically and preferably simultaneously treated at each of the coating rollers used in the process. In other words, two first coating rollers and two second coating rollers are employed for contact with the upper and lower substrate surfaces, respectively, and the two first and two second coating rollers are positioned and aligned such that the upper surface is provided with its first application of liquid photoresist essentially at the same time as the lower surface is provided with its first application of liquid photoresist, and the upper surface is provided with its second application of liquid photoresist essentially at the same time as the lower surface is provided with its second application of liquid photoresist. Here again, the two first and two second coating rollers can all be embodied in a single roller coater or, alternatively, in a separate roller coater embodying the two first coating rollers and a separate roller coater embodying the two second coating rollers, or also alternatively, each coating roller can be embodied in a separate roller coater device.

The process of the present invention provides a highly economical means for achieving uniform, defect-free coatings of liquid photoresist of any desired thickness on substrate surfaces, and thus permits the fabricator to take advantage of the simplicity and control offered by roller coating without having to incur the penalty of high defect rates and/or low throughputs.

The process of the present invention is applicable for use with any of the common planar substrates used in the fabrication of printed circuit boards. The substrates are generally composed of non-conductive materials, such as thermoplastic or thermosetting polymeric materials or resins, ceramics, glass and the like. Typically, the substrate will be based upon epoxy or polyimide resins, generally reinforced with glass fibers. At the time of application of photoresist, the substrate can consist of the non-conductive material per se or can alternatively consist of the non-conductive material having a metal coating on one or both of its surfaces (e.g., metal foil cladding and/or electroless metal deposit, etc.). The planar substrate may have holes punched or drilled therethrough at predetermined areas where through-hole connections will be made.

As earlier noted, the process of the present invention is particularly applicable to the processing of innerlayers used in the fabrication of multilayer printed circuit boards.

The photoresist for use in the present invention can be any of the known liquid light-sensitive compositions conventionally used in the art, and typically comprising a solvent-containing mixture of a light-sensitive material which is either polymeric per se or admixed with a polymeric binder material. The photoresist can be positive-working or negative-working depending upon desired needs, but generally will be positive-working when used to coat innerlayers. The most common positive-working resists are those based upon o-quinonediazide light-sensitive compounds and phenol-aldehyde condensation polymers (e.g., novolaks) as the binder resin.

The substrate surface to be coated according to the invention generally will be processed to insure a clean surface, free of oils, dirt, debris or other contaminants. Where the substrate is metal-clad, suitable microetchants typically will be employed to improve adhesion between the metal surface and the photoresist coating. As regards cleaning, the prevalence of pin hole defects in prior art roller coating methods has led to the general practice of insuring the cleanest possible surfaces so as to avoid any contaminants which might produce these coating defects, adding time and expense to the process, often without any real corresponding benefit as to the frequency of defective coatings. The ease with which the coating process of the present invention produces defect-free coatings renders the substrate cleaning process much less critical. While steps are still taken to insure clean surfaces, the steps need not be so rigorous as those practiced heretofore in the art, and less-than-perfect cleaning less frequently results in defective coatings.

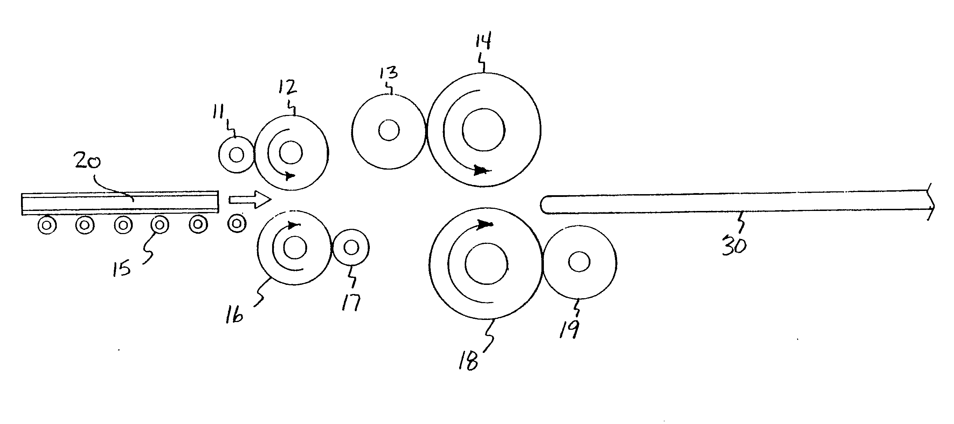

A preferred embodiment of the invention will now be described, by way of example only, with reference to the accompanying drawing, the sole Figure of which shows a side view schematic illustration of a roller coating arrangement according to the invention for the double-sided coating of a planar substrate.

Referring to the Figure illustrating the preferred embodiment of the invention, an innerlayer 20 is shown as the planar substrate. The innerlayer 20 is a copper-clad epoxy-glass substrate. Innerlayer 20, after suitable cleaning and microetching, is conveyed along feed conveyor 15 and then taken up by opposed first coating rollers 12 and 16 which rotate in counterclockwise and clockwise directions, respectively, to advance innerlayer 20 therebetween for application of a layer of liquid photoresist to the upper and lower surfaces thereof.

In this particular embodiment, coating rollers 12 and 16 are smooth rubber coating rollers and have associated therewith stationary doctor bars 11 and 17. Liquid photoresist is flowed continuously, from a suitable source (not shown), between the coating roller and the doctor bar and is then applied to the innerlayer surfaces advancing in contact with the rolling rollers. Suitable pumps, collection, and recycling means are also provided for delivering photoresist to the coating roller, recovering excess photoresist, and recycling excess photoresist to the source supply.

The thickness of photoresist layer applied to the innerlayer upper or lower surfaces by means of smooth rubber coating rollers is essentially a function of the viscosity of the photoresist, the rotational speed of the coating rollers (i.e., the contact time of the substrate surface with the coating roller) and the spacing between the doctor bar and the coating roller. These parameters are varied, taking into account desired throughput and particular photoresist composition, to arrive at a suitable layer thickness. The thickness of the layer applied to the upper or lower substrate surface by these first coating rollers (e.g., coating roller 12 or 16) is less than the eventually-desired coating thickness, and typically will be from about 10 to about 50% of the final desired coating thickness. For most commonly-employed photoresists and printed circuit manufacturing processes, the ultimately desired final coating thickness will be between about 7 and 12 microns, and hence the layer thickness resulting from contact with the first coating rollers will be on the order of from about .7 to about 6 microns.

After receiving this applied liquid photoresist layer from the first coating rollers, innerlayer 20 is advanced, without change in planar orientation, to the second coating rollers 14 and 18, also associated with doctor bars 13 and 19, respectively, and with means for supplying photoresist thereto, etc. The downstream distance of the second coating rollers from the first coating rollers is generally small (and will particularly be so when first and second coating rollers are embodied in a single roller coater device), and is at least short enough such that the layer of photoresist on the substrate surfaces from the first coating rollers is still liquid when photoresist from the second coating rollers is applied thereto. Preferably, this distance between the first and second coating rollers, and the conditions of coating, are such that, at the time additional photoresist is applied by the second coating rollers, the photoresist layer from the first coating rollers has essentially the same viscosity as first applied, and essentially the same viscosity as the photoresist applied by the second coating rollers, so as to achieve good intermixing at surface boundaries and filling in or smoothing of any defects in the first applied layer of photoresists. Also, the preferred downstream location of the second coating rollers will be such that the substrate advanced out of contact with the first coating rollers will be smoothly taken up by the rotating second coating rollers without need for additional conveying means.

The substrate surfaces onto which liquid photoresist has been applied as a layer by the first coating rollers advance into contact with these second coating rollers 14 and 18 which apply to the surfaces additional liquid photoresist so as to arrive at the final desired coating thickness. In the preferred embodiment shown in the Figure, these second coating rollers are "grooved" or "threaded" rollers which are particularly useful for application of positive photoresists (which are generally of low viscosity) in the coating thicknesses required. See generally DeForest, supra, at pp. 137-143, and U.S. Patent No. 3,535,157, incorporated herein by reference. The particular type of grooved roller (e.g., threads per inch and thread angle) will be chosen based upon the thickness of additional photoresist coating needed over the first layer in order to obtain the desired final coating thickness, taking into account roller speed, photoresist viscosity and doctor bar pressure.

Following the coating operation, the coated substrate is engaged by an edge gripper conveyor 30 to advance the substrate into a suitable drying station.

The illustrated arrangement in the Figure is simply the preferred arrangement and, as earlier noted, many variations are possible, including use of grooved coating rollers for both the first and second coating rollers; single-sided coating using support/driving rollers and backing plates; use of stationary or rotating doctor rollers; and the like.

So too, it will be appreciated that fundamentally the method of the present invention involves application to a substrate surface of a first layer of liquid photoresist by means of a first coating roller, the layer of liquid photoresist so applied being less than the ultimately desired photoresist coating thickness, followed by application, over the first applied layer of liquid photoresist, and without planar reorientation of the substrate surface, of additional liquid photoresist by means of a second coating roller, such that a uniform, defect-free coating of the ultimately desired thickness of liquid photoresist is obtained on the substrate surface. Within the context of this fundamental process, any number of variations may be practiced. As already mentioned, the coating rollers can be housed in a single roller coater apparatus or in separate roller coaters, and the process can be used to sequentially, or preferably simultaneously, coat both upper and lower surfaces of a substrate. So too, additional coating rollers can be employed in the process, such as in processes where the substrate surface might sequentially receive photoresist from three or more separate coating rollers, again without change in planar orientation of the substrate as it advances from one coating roller to the next, each coating roller applying a quantity of liquid photoresist so that the photoresist sequentially builds up to the ultimately desired coating thickness. Also, non-coating rollers also can be included in the process, e.g., rollers for use in smoothing applied liquid photoresist.

The following example is presented in further illustration of the invention and the preferred embodiment, and comparison to prior art practices.

An 18 x 24 inch copper-clad (5 mil) innerlayer was cleaned according to the following process sequence:

1. Alkaline spray cleaner -- 1 minute
2. Water rinse
3. Water rinse
4. Peroxide/sulfuric acid microetchant -- 1 minute
5. Water rinse
6. Dry

The panel was transferred to a Class 100 Clean Room and then coated on both sides with liquid positive photoresist (coating thickness of 10 microns) in a double-sided roller coating process using grooved rollers above and below the panel. After coating and drying, inspection of the panel showed 15 pin holes of various sizes where no photoresist was present.

According to the invention, the same type of innerlayer panel was cleaned in the above sequence and transferred to the Clean Room. Double-sided coating was effected using first, smooth rubber roller coaters above and below the panel to apply a layer (4 microns thick) of the photoresist composition to the surfaces. The panel was then directly advanced, without change in planar orientation, to second, grooved roller coaters above and below the panel to apply additional photoresist composition to the desired final thickness of 10 microns. Upon drying and inspection, no pin holes were found.

## Claims

1. A method for applying a coating of liquid photoresist of predetermined desired thickness to a selected planar surface of a planar substrate having upper and lower planar surfaces, wherein the planar surface is advanced in contact with a coating roller supplied with a source of liquid photoresist to provide a coating of liquid photoresist of predetermined desired thickness on the planar surface, characterised in that the said planar surface is advanced in contact with a first coating roller supplied with a source of liquid photoresist to provide a first layer of liquid photoresist on the planar surface in a thickness less than the predetermined desired thickness for the coating, and thereafter the planar surface having the first layer of liquid photoresist thereon, is advanced without changing the planar orientation of the planar surface, in contact with a second coating roller, distinct from the first coating roller and supplied with a source of liquid photoresist, to provide additional liquid photoresist on the planar surface having the first layer of liquid photoresist thereon, in an amount sufficient to provide a substantially uniform, substantially defect-free coating of liquid photoresist of predetermined desired thickness on said planar surface.

2. A method according to claim 1, wherein both of the upper and lower planar surfaces are provided with said first layer of liquid photoresist by means of distinct first coating rollers in contact with the respective upper and lower planar surfaces, and both of the upper and lower surfaces, each having a first layer of liquid photoresist thereon, are thereafter provided with an additional liquid photoresist by means of distinct second coating rollers.

3. A method according to claim 2, wherein the upper and lower planar surfaces are provided with the first layer of liquid photoresist substantially simultaneously, and wherein the upper and lower planar surfaces, having the first layer of liquid photoresist thereon, are provided with the additional liquid photoresist substantially simultaneously.

4. A method according to claim 1 or 2, wherein the first coating roller and the second coating roller have different contacting surfaces.

5. A method according to claim 1, 2 or 3, wherein the first coating roller is a smooth rubber roller and wherein the second coating roller is a grooved coating roller.

6. A method according to any one of the preceding claims, wherein the planar substrate is a metal-coated insulating substrate.

7. A method according to any one of the preceding claims, wherein the planar substrate is a metal-coated inner-layer for a multilayered printed circuit board, and wherein the liquid photoresist is a positive-acting photoresist.

8.  A method according to any one of the preceding claims, wherein the thickness of the first layer of liquid photoresist provided on the planar surface is from about 10 to about 50% of the predetermined desired thickness of the liquid photoresist coating on the planar substrate surface.

9.  A method for applying a substantially uniform, substantially defect-free coating of liquid photoresist of desired thickness to a planar substrate surface, comprising the steps of:
    (a) advancing said planar substrate surface in contact with a first, smooth-surfaced, coating roller supplied with a source of liquid photoresist composition to provide on said planar substrate surface a first layer of said liquid photoresist having a thickness of from about 10 to about 50% of the desired coating thickness;
    (b) advancing said planar substrate surface having said first layer of liquid photoresist thereon, without change in planar orientation of said planar substrate surface, in contact with a second, grooved surface, coating roller supplied with a source of liquid photoresist to provide additional liquid photoresist on said planar substrate surface having said first layer of liquid photoresist thereon, in an amount sufficient to obtain the desired thickness of liquid photoresist coating on said planar substrate surface.